# EUROPEAN PATENT SPECIFICATION

(11) **EP 1 606 976 B1**
(45) Date of publication and mention of the grant of the patent: **11.07.2007**
(21) Application number: 04757805.9
(22) Date of filing: 19.03.2004
(51) Int. Cl.: H05B 3/16

(54) **MICA BOARD ELECTRICAL RESISTANCE WIRE HEATER , SUBASSEMBLIES COMPONENTS, AND METHODS OF ASSEMBLY**
ELEKTRISCHES WIDERSTANDSDRAHTHEIZELEMENT FÜR EINE MICA-PLATTE, BAUGRUPPENKOMPONENTEN UND AUFBAUVERFAHREN
CHAUFFAGE A CABLE DE RESISTANCE ELECTRIQUE DE MICANITE, ELEMENTS DE SOUS ENSEMBLE ET PROCEDES D'ASSEMBLAGE

(30) Priority: 21.03.2003 US 392879
(43) Date of publication of application: 21.12.2005
(73) Proprietor: Tutco, Inc., Cookeville, TN 38506 (US)
(72) Inventor: HOWARD, H., Keith, Cookeville, TN 38506 (US); KIRBY, Robert, Sparta, TN 38583 (US)
(74) Representative: Harrison, Ivor Stanley
(86) International application number: PCT/US2004/008276
(87) International publication number: WO 2004/086819

(56) References cited:
- EP-A- 0 033 788
- WO-A-02/089527
- DE-A- 2 129 468
- GB-A- 191 021 469
- GB-A- 191 121 026
- GB-A- 191 215 275
- US-A- 1 694 600
- US-A- 2 485 852
- US-A1- 2002 185 491

## Description

### Field of the Invention

The present invention is directed to a mica board electrical resistance wire heater, subassemblies, components, and methods of assembly, and in particular to the use of a clip on the mica boards to interconnect the resistance wire to power conductors and a ceramic terminal block that permits the use of push on terminals.

### Background Art

In the prior art, it is common to use plates, boards or sheets of various forms of mica in open air resistance heaters. Typically, a resistance wire is wrapped around the mica boards and mounted in a heater frame. The techniques used to wind the wire around the mica boards are well known, as is the technique for delivering power to the heating element terminals by a direct connection using insulated lead wires.

One problem with these types of mica board heaters is the number of manufacturing steps needed to make the heater. Presently, metal clips are first attached to the mica boards by riveting in a separate operation. Then, the resistance wire is wound around the mica board to form the subassembly of mica board and resistance wire. This operation is time consuming since a separate and distinct manufacturing step is required for attaching the clips to the mica boards.

GB M15275A describes an electrical connection clip for securing ends of a resistance wire wound on a mica board.

Another problem with these types of heaters is the inability to use push on terminals for connection purposes. These heaters are designed with either mica terminal plates or metal terminal plates to electrically isolate energized wires and/or components. In either instance, electrical connection is accomplished by riveting terminals to the mica plate and the end of the resistance wire, which is a highly undesirable connection. Push on terminals cannot be used since mica is not strong enough to withstand the force required to properly connect a push on terminal.

Accordingly, a need exists to eliminate the weak and unreliable connections used in the prior art and extra manufacturing steps. The present invention responds to this need by providing a clip as part of a heater subassembly that removes the additional and separate step of riveting the clip to the mica board. The present invention also eliminates the need for riveting terminals to the mica board and ends of resistance wires. The present invention also provides a subassembly, which improves manufacturing by substituting welding riveting when making electrical connections as part of a heater. The present invention also overcomes the inability to use push on terminals with mica board heaters.

### Summary of the Invention

A first object of the present invention is an improved electrical connection clip for mica board heater subassemblies.

Another object of the invention is a heater subassembly, which provides terminals for welding connections during heater assembly.

A still further object of the invention is a two-pole ceramic terminal block for a heater that permits push on terminal connections.

Yet another object of the invention is a method of heater assembly wherein heater subassemblies can be put together using automation.

Other objects and advantages of the present invention will become apparent as the description thereof proceeds.

In satisfaction of the foregoing objects and advantages, the present invention is an improvement in mica board open air resistance heaters. In one aspect, the invention provides a unique clip for attachment to a mica board and to facilitate electrical connection to ends of the resistance wire wrapped around the boards, as well as a heater subassembly combining the wire, mica boards, and clips.

The clip has a u-shaped body with first and second legs joined at one end to form a channel that is sized to capture a portion of the mica board. A first flange extends from an end of the first leg, the flange including a bendable tab at an end thereof. Bending of the tab towards the flange secures an end of the resistance wire to the clip. A second flange extends from an end of the second leg, the second flange being aligned generally with the first flange and forming a terminal for connection to a bus wire of a terminal plate subassembly. The clip can be retained via a spring bias of the legs or employ a tab extending from each leg forming the channel for engagement with the mica board. The tabs can interface with an opening in the mica board for retention purposes.

The subassembly of mica boards, resistance wire, and clips can be mounted to a frame for automated assembly with a terminal plate heater subassembly. A number of the subassemblies can be mounted between the frame plates depending on the desired heater capacity.

The invention also includes a heater assembly using the subassembly of the mica boards, the resistance wire, the clips, and the frame and another subassembly having a terminal plate with a terminal block and thermostat mounted thereon and being electrically connected together. The other subassembly has a first bus wire extending from one thermostat terminal and a second bus wire extending from one terminal of the terminal block. Each bus wire is electrically connected to a respective bus wire terminal so that power can be supplied to the resistance wire.

Another aspect of the invention is the use of a ceramic terminal block in the terminal plate subassembly. The terminal block is directly mounted to the metal terminal plate and employs a pair of block terminals adapted to received push on terminals of power conductors. This aspect of the invention also entails a method of connecting the electrical conductors to the terminals of a ceramic two-hole terminal block that is directly mounted to the metal terminal plate. The terminals of the pair of power conductor terminals are pushed onto the block terminals without damage to the block or terminal plate.

Another method aspect of the invention involves an improvement in electrically connecting the electrical resistance wire wound around the pair of mica boards. In this method, the electrical connection clip is clipped onto one end of each of the mica boards and each end of the resistance wire that is wrapped around the mica board pair is secured to a respective flange of each of the electrical connection clips. The thus assembled mica boards, resistance wires and clips are then mounted to the frame to form the mica board subassembly. This subassembly is aligned with the terminal plate subassembly and the bus wires thereof are welded to the bus wire terminals so that electrical power can be supplied to the electrical resistance wire.

### Brief Description of the Drawings

Reference is now made to the drawings of the invention wherein:
Figure 1 is a perspective view of an electrical connection clip of the invention;
Figure 2 is a side view of the clip of Figure 1;
Figure 3 is a view along the line III-III of Figure 2;
Figure 4 is a side view of a mica board for use with the clip of Figure 1;
Figure 5 is a top view of a first heater subassembly of the invention;
Figure 6 is an end view of the subassembly of Figure 5 enlarged to show greater detail;
Figure 7 is a side view detail of the clip attached to an end of the mica board of Figure 4;
Figure 8 is a top view of a second heater subassembly of the invention;
Figure 9 is a side view of the subassembly of Figure 8;
Figure 10 is a top view of a third heater subassembly;
Figure 11 is a side view of the subassembly of Figure 10;
Figure 12 is a top view of a terminal block of the invention;
Figure 13 is a partial side and partial cross section view of the block of Figure 12;
Figure 14 is a bottom view of the block of Figure 12;
Figure 15 is a top view of a heater of the present invention incorporating the subassembly of Figures 8 and 10.

### Description of the Preferred Embodiments

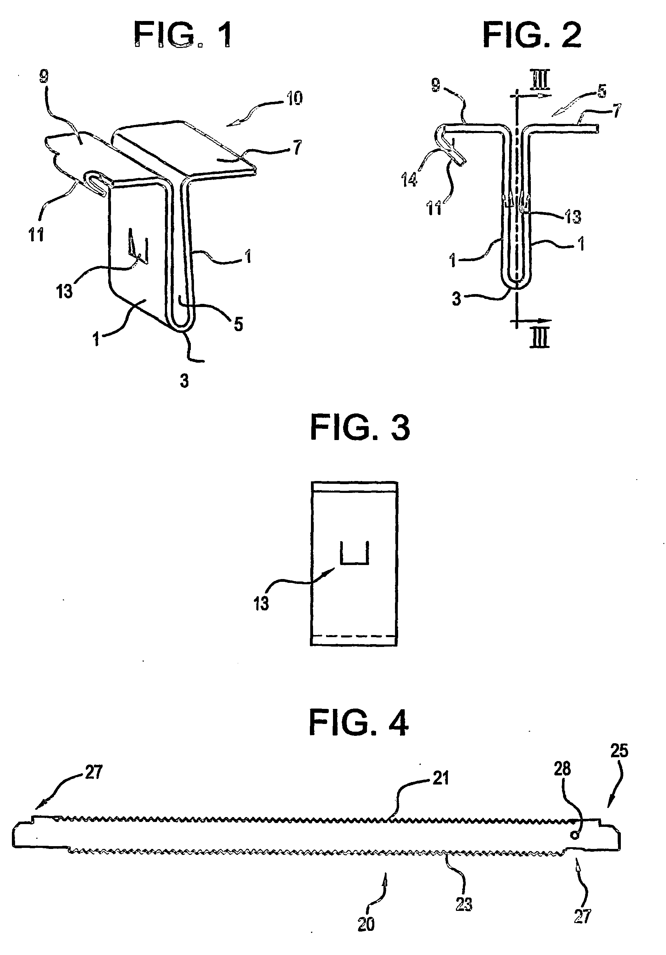

Referring now to Figures 1-3, a clip for making an electrical connection with the resistance wire of a mica board heater is designated by the reference numeral 10. The clip 10 has a pair of legs 1, which are joined at 3 to form a u-shape. The legs 1 have a spring bias inward and form a channel 5, which is sized to receive or capture a mica board that is part of the heater as will be shown later.

One leg of the clip terminates in a flange 7 with the other leg of the clip terminating in a flange 9. The flange 9 includes a bendable tab 11 on an end thereof. Each leg also has a second tab 13, which extends into the channel 5 and helps retain the mica board in place with the bias of the clip legs pressing against the mica board sides.

The bendable tab 11 and flange 9 form a space 14 which is designed to receive a part of the end of the resistance wire that is wound around the mica board. The flange 7 is designed to receive a bus wire to electrically interconnect the resistance wire to power.

Referring now to Figure 4, an exemplary mica board is designated by the reference numeral 20 and has a number of grooves 21 and 23 disposed on edges of the board. The grooves 21 and 23 receive the resistance wire windings and maintain the proper spacing between the wires. The ends 25 and 27 of the mica board are configured to connect to an opening in a heater frame component as detailed below. One end 25 is also configured to receive the clip 10 by the presence of a recess 27, which engages the junction 3 of the clip. The mica board end 25 also has an opening 28 which is sized and located to interface with the tabs 13 to keep the clip 10 in place.

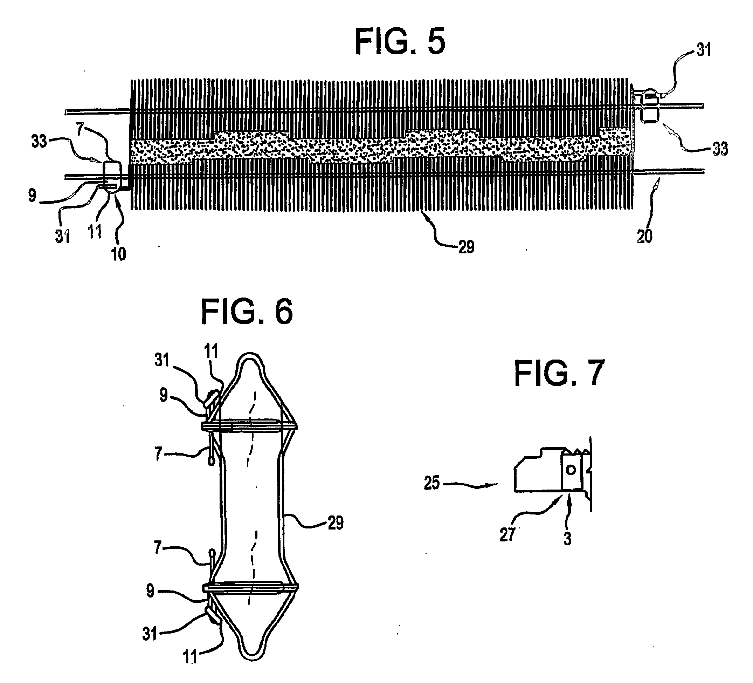

Referring now to Figures 4-7, a pair of mica boards 20 are shown with a resistance wire 29 wrapped therearound. A clip 10 is mounted at each end 25 of the board, with each end 31 of the wire 29 crimped between the flange 9 and bendable tab 11 of each clip 10. The flange 7 forms a terminal 33, which permits making electrical connection between the ends 31 of the resistance wire 29 and a bus bar or jumper wire of the heater, as described below. Although not shown, the flange 9 is preferably bent downward and toward the junction 3 of the clip 10 so that the wire end 31 that is curled over the flange 9 does not interfere with a subsequent attachment of the flange 7 to the bus wire. The combination of the mica boards 20, the wire 29 and the clips 10 forms a subassembly 30, which can be further used to make the mica heater.

The clip 10 is advantageous in its ability to make an electrical connection or termination of the ends 31 of the wire 29 without the need for a riveting operation to attach the clip to the mica board. The clip design and presence of the flanges 7 and 9 is particularly beneficial by forming surfaces which allows for attachment to the resistance wire end and a welded connection to a bus wire, thus permitting the connection with the bus or jumper wire of another frame subassembly to be easily automated.

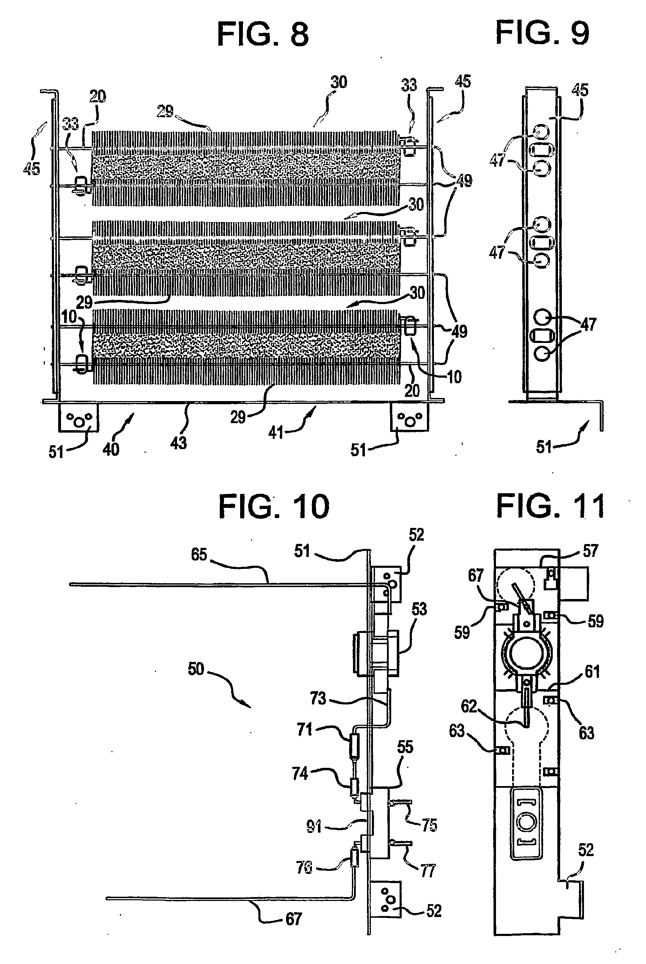

Figures 8 and 9 show a second heater subassembly 40 wherein a number of subassemblies 30 are mounted in a frame 41. The frame 41 comprises an end plate 43, and a pair of side plates 45. Each side plate 45 has openings 47, which are sized to receive ends 49 of the mica boards 20. The plates 43 and 45 can be connected in any fashion but are preferably welded together. The end plate 43 includes a pair of mounting flanges 51 for heater attachment purposes in the environment of use.

As is apparent from Figure 8, the terminals 33, as formed by the flange 7 of each clip 10, are aligned along each side plate 45 to facilitate the automated assembly of the heater with another subassembly 50 as shown in Figures 10 and 11.

The subassembly 50 includes a metal terminal plate 51, which has mounted thereon, a thermostat 53, and a terminal block 55. The plate 51 also has flanges 52, similar to those in the subassembly 40 for heater attachment purposes. Referring to Figure 11, a first mica insulator plate 57 is mounted on the metal plate 51 and is held in place by fold over tabs 59. The tabs 59 are formed by punching out the tab from the plate 51, but other attachment techniques could be used to secure the plate 57 in place. A second mica insulator 61 is also mounted on the metal plate 51 and held in place with tabs 63. The mica plates 57 and 61 isolate the energized wires and/or other components of the heater.

The subassembly 50 also includes a pair of bus or jumper wires 65 and 67. Wire 65 passes through a hole in the mica plate 57 and is welded to a terminal 69 of the thermostat 53. The wire 65 extends beyond the plate 51 in a generally perpendicular direction with respect to the plate 51, and is intended to make an electrical connection with the terminals formed by the flanges 7.

Continuing to refer to Figures 8 and 9, a temperature sensing fuse 71 is provided, one end passing through an opening 62 in the plate 61 and being welded to the other terminal 73 of the thermostat 53. The other lead of the fuse 71 is attached to one end 74 of a terminal 75 passing through one hole of the terminal block 55. The terminal 75 is intended to accept a push on terminal attached to the end of the first of two electrical power conductors.

The other bus wire 67 has one end attached to an end 76 of the second terminal 77 in the block 55. As with the first terminal 75, the second terminal 77 is also designed to accept a push on terminal attached to the end of the second of the two electrical power conductors. The bus wire 67 then extends in a direction similar to bus wire 65 for attachment to clips 10 of the subassembly 40.

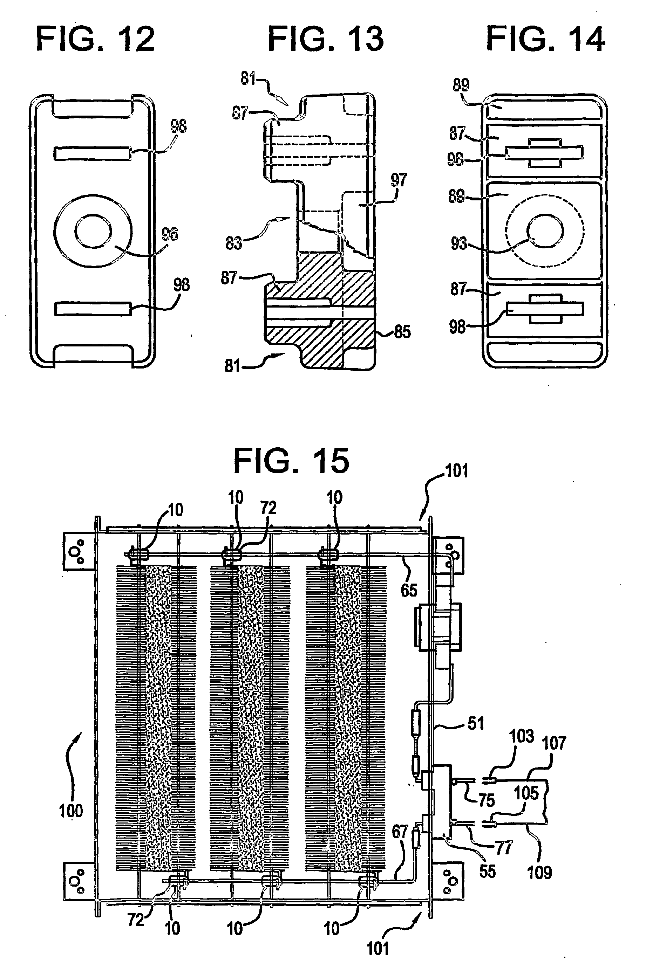

The terminal block 55 is shown in more detail in Figures 12-14. The block is made of a ceramic material and has terminal hole portions 81, which are interconnected by middle portion 83. The terminal hole portions 81 and middle portion 83 form a flat face 85 serving as a bottom of the block 55. Opposite ends of the hole portions 81 are stepped to form rectangular protrusions 87 extending from surface 89. The protrusions 87 extend through a pair of openings (not shown) in the metal plate 51 with the surfaces 89 abutting the plate when the block is attached thereto, see Figure 10. The fastening of the block 55 occurs by the use of a rivet 91 and a stepped throughhole 93 in the middle portion 83, see Figure 10. The rivet extends through hole 93 and engages the plate 51 and the face 96 in the recess 97 to secure the block in place. Each hole portion 81 has an opening 98 which is configured to receive and retain the terminals 75 and 77.

The use of the ceramic two hole block in combination with the metal plate 51 allows the use of push on terminals to connect the power conductors to the terminals 75 and 77. The ceramic block backed up by the metal plate 51 is capable of withstanding the force applied during automated push on terminal connection. This contrasts with the thin gauge mica plates 57 and 61 and metal plate 51, the combination thereof not capable of withstanding such a force application.

Figure 15 shows an assembled heater 100 wherein the heater subassembly 40 is combined with the heater subassembly 50. In assembling the heater, it can be seen that the bus wires align with respective sets of the clips 10 so that the connection between the bus wires and clips 10 can be easily made by welding. As part of the assembly 100, ends of the frame plates 45 of the subassembly 40 are welded to the terminal plate 51 at 101. The presence of the flanges 7 on the clips provides a ready surface for the welded connection to the bus wires 65 and 67. Further, the clip design allows the assemblies to be put together using an automated process, and manufacturing speed is greatly increased. The prior art step whereby the clips are attached using a separate process is eliminated; the clip attachment and welding operation can be done as part of one sequence.

Figure 15 also shows a pair of push on terminals 103 and 105 connected at the ends of power conductors 107 and 109. These terminals are pushed onto the terminals 75 and 77 of the terminal block 55 as a result of the ceramic nature of the block 55 and its capability of withstanding the push on force from the terminals 103 and 105.

The inventive clip also provides for improvements in the method of assembling the various heater subassemblies. The clip 10 can be merely slid onto the mica board 20 and retained by spring bias or, if present in the clips 10 and boards 20, the tabs 13 and openings 28 can be used as described above. This operation can be done in the same venue as the winding of the resistance wires on the mica boards, and the extra and separate riveting step mandated in the prior art is eliminated. Once the clip 10, wire 29, and mica boards 20 are assembled, this subassembly 30 can be mounted in the frame plates as shown in Figure 8 to form the subassembly 40. As an alternative, the clips 10 can be attached after winding of the wires on the mica boards, and this step can be performed during the final assembly stage of the heater or as part of other steps of assembly following the winding step. It should also be understood that the flange 9 could be used as a terminal for welding with the bus wire if so desired, although it is preferred that flange 7 be used since the resistance wire is not present and welding is less complicated.

The subassembly 40 is then mated with the subassembly 50 so that the bus wires 65 and 67 can be welded to the terminal flanges 7 at 72, and the ends of the frame plates 45 can be secured to the terminal plate 51. The entire assembly can then be mounted in the desired location for heating; the power conductors can be pushed onto the terminals 75 and 77 at the appropriate time. Linking the subassemblies together can be done using automation whereby the various components are positioned to have such steps as welding done automatically so that the manufacturing process is low cost and quick.

It should be understood that the invention described above is one embodiment, but other variations may be made without departing from the scope of the invention. For example, while the tab 13 is shown as part of the clip 10, and the mica board is provided with a corresponding opening 28, it is believed that the tab 13/opening 28 could be eliminated in situations wherein the bias of the clip would be sufficient to hold the clip in place. Alternatively, another type of engaging protrusion could be fashioned as part of the clip to retain it in place on the mica board 20.

Although Figure 8 shows a number of subassemblies 30 arranged between the frame plates 45, one, two, or more than three subassemblies can be linked together. Further, a number of the subassemblies 40 could be combined as one heater apparatus. The assembled heater can be used in any apparatus or device that requires these types of heaters.

As such, an invention has been disclosed in terms of preferred embodiments thereof which fulfills each and every one of the objects of the present invention as set forth above and provides a new and improved mica board open air electric resistance heater, and subassemblies and components thereof, and methods of assembly.

Of course, various changes, modifications and alterations from the teachings of the present invention may be contemplated by those skilled in the art without departing from the intended scope thereof. It is intended that the present invention only be limited by the terms of the appended claims.

## Claims

1. An electrical connection clip (10) for securing ends of a resistance wire (29) wound on a mica board (20), **characterized in that** the clip (10) comprises:
a) a u-shaped clip body having first and second legs (1) joined at one end to form a channel (5) sized to capture a portion of the mica board (20),
b) a first flange (9) extending from an end of the first leg (1), the flange (9) including a bendable tab (11) at an end thereof, bending of the tab (11) towards the flange (9) securing an end of the resistance wire (29) to the clip; and
c) a second flange (7) extending from an end of the second leg (1), the second flange (7) aligned generally with the first flange, the size of the second flange being of sufficient area to form a terminal for connection to a bus wire (65, 67) of a heater assembly using one or more resistance wire-containing mica boards (20).

2. The clip of claim 1, wherein each leg (1) has a capture tab (13) extending from a surface forming the channel (5) for the capture.

3. A resistance wire heater subassembly (30), **characterized in that** the subassembly comprises a pair of mica boards (20) and a resistance wire (29) wound around the pair of mica boards; and a pair of electrical connection clips (10), each electrical connection clip comprising:
a) a u-shaped clip body having first and second legs (1) joined at one end to form a channel (5) sized to capture a portion of the mica board (20);
b) a first flange (9) extending from an end of the first leg (1), the flange (9) including a bendable tab (11) at an end thereof, bending of the tab (11) towards the flange (9) securing an end of the resistance wire (29) to the clip; and
c) a second flange (7) extending from an end of the second leg (1), the second flange aligned generally with the first flange to form a terminal for connection to a bus wire (65, 67) of a heater assembly using one or more resistance wire-containing mica boards (20);
wherein each clip (10) is clipped onto an end of one of the mica boards (20), and each end of the resistance wires (29) is secured between the tab (11) and first flange (9) of a respective electrical connection clip.

4. The resistance wire heater subassembly of claim 3, wherein each leg (1) has a capture tab (13) extending from a surface forming the channel, each tab (13) engaging a portion of the mica board (20) when positioned in the channel.

5. The resistance wire heater subassembly of claim 3 or claim 4, wherein each mica board (20) has an opening (28) to receive the capture tab (13) of a respective electrical connection clip (10).

6. The resistance wire subassembly of any of claims 3 to 5, wherein the resistance wire heater subassembly (30) is mounted to a frame (41) for automated assembly with a terminal plate heater subassembly (50).

7. The subassembly of claim 6, comprising a plurality of resistance wire heater subassemblies (30), each of the resistance wire heater subassemblies mounted to the frame (41) to form a pair of aligned clip sets for automated assembly with a terminal plate heater subassembly (50).

8. A heater assembly (100) comprising:
a) a first heater subassembly (30) comprising a resistance wire (29) wound around a pair of mica boards (20), and a pair of electrical connection clips (10) according to claim 1 or claim 2, wherein each clip (10) is clipped onto an end of one of the mica boards (20), and each end of the resistance wire (29) is secured to a flange (9) of the electrical connection clip, the clip including a bus wire terminal (33) and the mica boards mounted to a frame (41); and
b) a second heater subassembly (50) having a terminal plate (51) with a terminal block (55) and thermostat (53) mounted thereon and being electrically connected together, a first bus wire (65) extending from one thermostat terminal (69), and a second bus wire (67) extending from one terminal (77) of the terminal block (55);
c) wherein each bus wire (65, 67) is electrically connected to a respective bus wire terminal (33) so that power can be supplied to the resistance wire.

9. The heater of claim 8, comprising a plurality of first heater subassemblies (30), each mounted to the frame (41) to form opposed sets of aligned bus wire terminals (33), each bus wire (65, 67) aligned and electrically connected with one of the set of aligned bus wire terminals (33).

10. An open air resistance heater comprising:
at least a pair of mica boards (20) with a resistance wire (29) wrapped around the board (20); and
a pair of electrical connection clips (10), according to claims 1 or 2, each mica board clip (10) being clipped onto an end of each mica board (20), each end of the resistance wire (29) attached to a flange (9) of each of the clips, the clip (10) including a bus wire terminal (33) adapted to connect with a bus wire (65, 67) to complete an electrical connection for the heater.

11. A method of making a mica board electrical resistance heater subassembly (30) having a number of mica boards (20) mounted to the heater, the method comprising mounting a clip according to claims 1 or 2 on an end of each mica board (20) and winding an electrical resistance wire (29) around each mica board (20), **characterized by** clipping an electrical connection clip (10) onto one end of each of the mica boards (20), the electrical connection clip (10) having a flange (7) and adapted to connect to a bus wire (65, 67) to supply power to the resistance wire (29); and
securing each end of the resistance wire (29) wrapped around each mica board to a respective flange (9) of each electrical connection clip (10).

12. The method of claim 11, further comprising mounting the mica board electrical resistance heater subassembly (30) to a frame (41).

13. The method of claim 11 or claim 12, further comprising welding a bus wire (65, 67) of a terminal plate heater subassembly (50) to each bus wire terminal (33) so that electrical power can be supplied to the electrical resistance wire (29).

14. The method of any of claims 11 to 13, wherein the electrical connection clip (10) further comprises:
a) a u-shaped clip body having first and second legs (1) joined at one end to form a channel (5) to capture a portion of the mica board (20),
b) the first flange (9) extending from an end of the first leg (1), the flange (9) including a bendable tab (11) at an end thereof, bending of the tab (11) towards the flange (9) securing an end of the resistance wire (29) to the clip (10); and
c) a second flange (7) extending from an end of the second leg (1) for connecting to a bus wire (65, 67).

15. The method of any of claims 11 to 14, further comprising using a plurality of mica board pairs (20) for the clipping and securing steps.

16. The method of any of claims 11 to 15, wherein the electrical connection clip (10) includes a pair of capture tabs (13) extending therefrom, and each mica board (20) has an opening (28) sized to engage the capture tabs (13) of a respective electrical connection clip (10), and the clipping step for each electrical connection clip includes engaging the opening (28) in the mica board (20) using the tabs (13).

17. The method of any of lcaims 11 to 16, further comprising mounting the mica board electrical resistance heater subassembly (30) to a frame (41).

## Patentansprüche

1. Elektrische Verbindungsklemme (10) zum Befestigen von Enden eines um eine Glimmerplatte (20) gewickelten Widerstandsdrahts (29), **dadurch gekennzeichnet, dass** die Klemme (10) aufweist:
a) einen U-förmigen Klemmenkörper mit einem ersten und einem zweiten Bein (1), die an einem Ende verbunden sind, um einen Kanal (5) zu bilden, der zum Halten eines Teils der Glimmerplatte (20) bemessen ist;
b) einen ersten Flansch (9), der sich von einem Ende des ersten Beins (1) erstreckt, wobei der Flansch (9) eine biegbare Zunge (11) an einem Ende davon enthält, wobei ein Biegen der Zunge (11) zum Flansch (9) ein Ende des Widerstandsdrahts (29) an der Klemme befestigt; und
c) einen zweiten Flansch (7), der sich von einem Ende des zweiten Beins (1) erstreckt, wobei der zweite Flansch (7) allgemein zum ersten Flansch ausgerichtet ist, wobei die Größe des zweiten Flansches eine ausreichende Fläche hat, um einen Anschluss zur Verbindung mit einem Busdraht (65, 67) einer Heizelementanordnung mit einem oder mehreren Widerstandsdrähte enthaltenden Glimmerplatten (20) zu bilden.

2. Klemme nach Anspruch 1, bei welcher jedes Bein (1) eine Haltezunge (13), die sich von einer den Kanal (5) bildenden Oberfläche erstreckt, für die Halterung aufweist.

3. Widerstandsdraht-Heizelementbaugruppe (30), **dadurch gekennzeichnet, dass** die Baugruppe ein Paar Glimmerplatten (20) und einen um das Paar Glimmerplatten gewickelten Widerstandsdraht (29) sowie ein Paar elektrischer Verbindungsklemmen (10) aufweist, wobei jede elektrische Verbindungsklemme aufweist:
a) einen U-förmigen Klemmenkörper mit einem ersten und einem zweiten Bein (1), die an einem Ende verbunden sind, um einen Kanal (5) zu bilden, der zum Halten eines Teils der Glimmerplatte (20) bemessen ist;
b) einen ersten Flansch (9), der sich von einem Ende des ersten Beins (1) erstreckt, wobei der Flansch (9) eine biegbare Zunge (11) an einem Ende davon enthält, wobei ein Biegen der Zunge (11) zum Flansch (9) ein Ende des Widerstandsdrahts (29) an der Klemme befestigt; und
c) einen zweiten Flansch (7), der sich von einem Ende des zweiten Beins (1) erstreckt, wobei der zweite Flansch allgemein zum ersten Flansch ausgerichtet ist, um einen Anschluss zur Verbindung mit einem Busdraht (65, 67) einer Heizelementbaugruppe mit einer oder mehreren einen Widerstandsdraht enthaltenden Glimmerplatten (20) zu bilden,
wobei jede Klemme (10) auf ein Ende einer der Glimmerplatten (20) geklemmt ist und jedes Ende der Widerstandsdrähte (29) zwischen der Zunge (11) und dem ersten Flansch (9) einer jeweiligen elektrischen Verbindungsklemme befestigt ist.

4. Widerstandsdraht-Heizelementbaugruppe nach Anspruch 3, bei welcher jedes Bein (1) eine Haltezunge (13) aufweist, die sich von einer den Kanal bildenden Oberfläche erstreckt, wobei jede Zunge (13) mit einem Abschnitt der Glimmerplatte (20) in Eingriff steht, wenn diese im Kanal angeordnet ist.

5. Widerstandsdraht-Heizelementbaugruppe nach Anspruch 3 oder 4, bei welcher jede Glimmerplatte (20) eine Öffnung (28) aufweist, um die Haltezunge (13) einer jeweiligen elektrischen Verbindungsklemme (10) aufzunehmen.

6. Widerstandsdraht-Heizelementbaugruppe nach einem der Ansprüche 3 bis 5, bei welcher die Widerstandsdraht-Heizelementbaugruppe (30) an einem Rahmen (41) zum automatisierten Zusammenbau mit einer Anschlussplatten-Heizelementbaugruppe (50) montiert ist.

7. Baugruppe nach Anspruch 6, mit mehreren Widerstandsdraht-Heizelementbaugruppen (30), wobei jede der Widerstandsdraht-Heizelementbaugruppen an dem Rahmen (41) montiert ist, um ein Paar ausgerichteter Klemmensätze zum automatisierten Zusammenbau mit einer Anschlussplatten-Heizelementbaugruppe (50) zu bilden.

8. Heizelementanordnung (100), mit
a) einer ersten Heizelementbaugruppe (30) mit einem um ein Paar Glimmerplatten (20) gewickelten Widerstandsdraht (29) und einem Paar elektrischer Verbindungsklemmen (10) nach Anspruch 1 oder 2, wobei jede Klemme (10) auf ein Ende einer der Glimmerplatten (20) geklemmt ist und jedes Ende des Widerstandsdrahts (29) an einem Flansch (9) der elektrischen Verbindungsklemme befestigt ist, wobei die Klemme einen Busdrahtanschluss (33) enthält und die Glimmerplatten an einem Rahmen (41) montiert sind; und
b) einer zweiten Heizelementbaugruppe (50) mit einer Anschlussplatte (51) mit einem Anschlussblock (55) und einem Thermostat (53), die darauf montiert sind und elektrisch miteinander verbunden sind, wobei sich ein erster Busdraht (65) von einem Thermostatanschluss (69) erstreckt und sich ein zweiter Busdraht (67) von einem Anschluss (77) des Anschlussblocks (55) erstreckt;
c) wobei jeder Busdraht (65, 67) mit einem jeweiligen Busdrahtanschluss (33) elektrisch verbunden ist, sodass dem Widerstandsdraht Strom zugeführt werden kann.

9. Heizelement nach Anspruch 8, mit mehreren ersten Heizelementbaugruppen (30), die jeweils an dem Rahmen (41) montiert sind, um gegenüberliegende Sätze von ausgerichteten Busdrahtanschlüssen (33) zu bilden, wobei jeder Busdraht (65, 67) zu einem der Sätze der ausgerichteten Busdrahtanschlüsse (33) ausgerichtet und mit diesem elektrisch verbunden ist.

10. Freiluft-Widerstandsheizelement, mit
wenigstens einem Paar Glimmerplatten (20) mit einem um die Platte (20) gewickelten Widerstandsdraht (29); und
einem Paar elektrischer Verbindungsklemmen (10) nach Anspruch 1 oder 2, wobei jede Glimmerplattenklemme (10) auf ein Ende jeder Glimmerplatte (20) geklemmt ist, jedes Ende des Widerstandsdrahts (29) an einem Flansch (9) jeder der Klemmen befestigt ist und die Klemme (10) einen Busdrahtanschluss (33) enthält, der zur Verbindung mit einem Busdraht (65, 67) ausgebildet ist, um eine elektrische Verbindung für das Heizelement zu vervollständigen.

11. Verfahren zum Herstellen einer elektrischen Widerstands-Glimmerplattenheizelementbaugruppe (30) mit einer Anzahl von Glimmerplatten (20), die an dem Heizelement befestigt sind, wobei das Verfahren das Montieren einer Klemme nach Anspruch 1 oder 2 an einem Ende jeder Glimmerplatte (20) und das Wickeln eines elektrischen Widerstandsdrahts (29) um jede Glimmerplatte (20) aufweist, **gekennzeichnet durch** Klemmen einer elektrischen Verbindungsklemme (10) auf ein Ende jeder der Glimmerplatten (20), wobei die elektrische Verbindungsklemme (10) einen Flansch (7) aufweist und zur Verbindung mit einem Busdraht (65, 67) ausgebildet ist, um dem Widerstandsdraht (29) Strom zuzuführen; und Befestigen jedes Endes des um jede Glimmerplatte gewickelten Widerstandsdrahts (29) an einem jeweiligen Flansch (9) jeder elektrischen Verbindungsklemme (10).

12. Verfahren nach Anspruch 11, ferner mit dem Montieren der elektrischen Widerstands-Glimmerplattenheizelementbaugruppe (30) an einem Rahmen (41).

13. Verfahren nach Anspruch 11 oder 12, ferner mit einem Schweißen eines Busdrahts (65, 67) einer Anschlussplatten-Heizelementbaugruppe (50) an jeden Busdrahtanschluss (33), sodass dem elektrischen Widerstandsdraht (29) Strom zugeführt werden kann.

14. Verfahren nach einem der Ansprüche 11 bis 13, bei welchen die elektrische Verbindungsklemme (10) ferner aufweist:
a) einen U-förmigen Klemmenkörper mit einem ersten und einem zweiten Bein (1), die an einem Ende verbunden sind, um einen Kanal (5) zum Halten eines Teils der Glimmerplatte (20) zu bilden;
b) den ersten Flansch (9), der sich von einem Ende des ersten Beins (1) erstreckt, wobei der Flansch (9) eine biegbare Zunge (11) an einem Ende davon enthält, wobei ein Biegen der Zunge (11) zum Flansch (9) ein Ende des Widerstandsdrahts (29) an der Klemme (10) befestigt; und
c) einen zweiten Flansch (7), der sich von einem Ende des zweiten Beins (1) zur Verbindung mit einem Busdraht (65, 67) erstreckt.

15. Verfahren nach einem der Ansprüche 11 bis 14, ferner mit der Verwendung mehrerer Glimmerplattenpaare (20) für die Klemm- und Befestigungsschritte.

16. Verfahren nach einem der Ansprüche 11 bis 15, bei welchem die elektrische Verbindungsklemme (10) ein Paar sich davon erstreckender Haltezungen (13) enthält und jede Glimmerplatte (20) eine Öffnung (28) besitzt, die zum Greifen der Haltezungen (13) einer jeweiligen elektrischen Verbindungsklemme (10) bemessen ist, und der Klemmschritt für jede elektrische Verbindungsklemme ein Greifen der Öffnung (28) in der Glimmerplatte (20) durch die Zungen (13) enthält.

17. Verfahren nach einem der Ansprüche 11 bis 16, ferner mit dem Montieren der elektrischen Widerstands-Glimmerplattenheizelementbaugruppe (30) an einem Rahmen (41).

## Revendications

1. Clip de connexion électrique (10) pour fixer les extrémités d'une résistance filaire (29) enroulée sur une plaque de mica (20), **caractérisé en ce que** le clip (10) comprend les éléments suivants :
a) un corps de clip en U présentant une première et une seconde jambe (1) jointives à une extrémité pour former un canal (5) dimensionné pour enserrer une partie de la plaque de mica (20),
b) un premier rebord (9) s'étendant depuis une extrémité de la première jambe (1), le rebord (9) comprenant une patte pouvant être recourbée (11) à une extrémité de celui-ci, le recourbement de la patte (11) vers le rebord (9) fixant une extrémité de la résistance filaire (29) sur le clip ; et
c) un second rebord (7) s'étendant depuis une extrémité de la second jambe (1), le second rebord (7) étant sensiblement aligné avec le premier rebord, la taille du second rebord représentant une surface suffisante pour former une borne pour la connexion à une barre collectrice (65, 67) d'un ensemble de chauffage utilisant une ou plusieurs plaques de mica comportant des résistance filaires (20).

2. Clip selon la revendication 1, dans lequel chaque jambe (1) présente une patte de fixation (13) s'étendant depuis une surface formant le canal (5) pour la capture.

3. Sous-ensemble de chauffage à résistance filaire (30), **caractérisé en ce que** le sous-ensemble comprend une paire de plaques de mica (20) et une résistance filaire (29) enroulée autour de la paire de plaques de mica ; et une paire de clips de connexion électrique (10), chaque clip de connexion électrique comprenant les éléments suivants :
a) un corps de clip en U présentant une première et une seconde jambe (1) jointives à une extrémité pour former un canal (5) dimensionné pour enserrer une partie de la plaque de mica (20),
b) un premier rebord (9) s'étendant depuis une extrémité de la première jambe (1), le rebord (9) comprenant une patte pouvant être recourbée (11) à une extrémité de celui-ci, le recourbement de la patte (11) vers le rebord (9) fixant une extrémité de la résistance filaire (29) sur le clip ; et
c) un second rebord (7) s'étendant depuis une extrémité de la second jambe (1), le second rebord étant sensiblement aligné avec le premier rebord pour former une borne pour la connexion à une barre collectrice (65, 67) d'un ensemble de chauffage utilisant une ou plusieurs plaques de mica comportant des résistances filaires (20) ;
dans lequel chaque clip (10) est clippé sur une extrémité d'une des plaques de mica (20), et dans lequel chaque extrémité des résistance filaires (29) est fixée entre la patte (11) et le premier rebord (9) d'un clip de connexion électrique respectif.

4. Sous-ensemble de chauffage à résistance filaire selon la revendication 3, dans lequel chaque jambe (1) présente une patte de fixation (13) s'étendant depuis une surface formant le canal, chaque patte (13) engageant une partie de la plaque de mica (20) une fois positionnée dans le canal.

5. Sous-ensemble de chauffage à résistance filaire selon la revendication 3 ou 4, dans lequel chaque plaque de mica (20) présente une ouverture (28) pour recevoir la patte de fixation (13) d'un clip de connexion électrique respectif (10).

6. Sous-ensemble à résistance filaire selon l'une quelconque des revendications 3 à 5, dans lequel le sous-ensemble de chauffage à résistance filaire (30) est monté sur une armature (41) pour un assemblage automatique avec un sous-ensemble de chauffage (50) à bornier.

7. Sous-ensemble selon la revendication 6, comprenant une pluralité de sous-ensembles de chauffage à résistance filaire (30), chacun des sous-ensembles de chauffage à résistance filaire étant monté sur l'armature (41) pour former une paire de jeux de clip alignés pour un assemblage automatique avec un sous-ensemble de chauffage (50) à bornier.

8. Ensemble de chauffage (100) comprenant les éléments suivants :
a) un premier sous-ensemble de chauffage (30) comprenant une résistance filaire (29) enroulée autour d'une paire de plaques de mica (20), et une paire de clips de connexion électrique (10) selon la revendication 1 ou 2, dans lequel chaque clip (10) est clippé sur une extrémité d'une des plaques de mica (20), et dans lequel chaque extrémité de la résistance filaire (29) est fixée à un rebord (9) du clip de connexion électrique, le clip comprenant une borne de barre collectrice (33) et les plaques de mica étant montées sur une armature (41) ; et
b) un second sous-ensemble de chauffage (50) comprenant une plaque à bornes (51) avec un bornier (55) sur laquelle est monté un thermostat (53) le tout étant mutuellement connecté électriquement, une première barre collectrice (65) s'étendant depuis une borne du thermostat (69), et une seconde barre collectrice (67) s'étendant depuis une borne (77) du bornier (55) ;
c) dans lequel chaque barre collectrice (65, 67) est connectée électriquement à une borne de barre collectrice (33) respective de sorte à alimenter électriquement la résistance filaire.

9. Ensemble de chauffage selon la revendication 8, comprenant une pluralité de premiers sous-ensembles de chauffage (30), chacun étant monté sur l'armature (41) pour former des jeux opposés de bornes de barre collectrice (33) alignées, chaque barre collectrice (65, 67) étant alignée et connectée électriquement à un des jeux de bornes de barre collectrice (33) alignées.

10. Ensemble de chauffage à résistance à l'air libre, comprenant les éléments suivants :
. au moins une paire de plaques de mica (20) avec une résistance filaire (29) enroulé autour de la plaque (20) ; et
. une paire de clips de connexion électrique (10) selon la revendication 1 ou 2, chaque clip de plaque de mica (10) étant clippé sur une extrémité de chaque plaque de mica (20), chaque extrémité de la résistance filaire (29) étant fixée à un rebord (9) de chacun des clips, le clip (10) comprenant une borne de barre collectrice (33) prévue pour être connectée à une barre collectrice (65, 67) pour compléter le raccordement électrique de l'ensemble de chauffage.

11. Procédé de fabrication d'un sous-ensemble de chauffage à résistance filaire et à plaque de mica (30) comportant un certain nombre de plaques de mica (20) montées sur l'ensemble de chauffage, le procédé comprenant le montage d'un clip selon la revendication 1 ou 2 sur une extrémité de chaque plaque de mica (20) et l'enroulement d'une résistance filaire (29) autour de chaque plaque de mica (20), **caractérisé en ce qu'**il comprend les étapes suivantes:
. pincement d'un clip de connexion électrique (10) sur une extrémité de chacune des plaques de mica (20), le clip de connexion électrique (10) présentant un rebord (7) et étant prévu pour être connecté à une barre collectrice (65, 67) pour alimenter la résistance filaire (29) en électricité ; et
. fixation de chaque extrémité de la résistance filaire (29) enroulée autour de chaque plaque de mica à un rebord (9) respectif de chaque clip de connexion électrique (10).

12. Procédé selon la revendication 11, comprenant en outre le montage du sous-ensemble de chauffage à résistance filaire et à plaque de mica (30) sur une armature (41).

13. Procédé selon la revendication 11 ou 12, comprenant en outre le soudage d'une barre collectrice (65, 67) d'un sous-ensemble de chauffage (50) à bornier à chaque borne de barre collectrice (33) de sorte que l'énergie électrique puisse être fournie à la résistance électrique filaire (29).

14. Procédé selon l'une quelconque des revendications 11 à 13, dans lequel le clip de connexion électrique (10) comprend en outre les éléments suivants:
a) un corps de clip en U présentant une première et une seconde jambe (1) jointives à une extrémité pour former un canal (5) prévu pour enserrer une partie de la plaque de mica (20),
b) un premier rebord (9) s'étendant depuis une extrémité de la première jambe (1), le rebord (9) comprenant une patte pouvant être recourbée (11) à une extrémité de celui-ci, le recourbement de la patte (11) vers le rebord (9) fixant une extrémité du fil de résistance (29) sur le clip ; et
c) un second rebord (7) s'étendant depuis une extrémité de la seconde jambe (1) pour la connexion à une barre collectrice (65, 67).

15. Procédé selon l'une quelconque des revendications 11 à 14, comprenant en outre l'utilisation d'une pluralité de paires de plaques de mica (20) pour les étapes de clipage et de fixation.

16. Procédé selon l'une quelconque des revendications 11 à 15, dans lequel le clip de connexion électrique (10) comporte une paire de pattes de fixation (13) s'étendant depuis celui-ci, et dans lequel chaque plaque de mica (20) présente une ouverture (28) dimensionnée pour engager les pattes de fixation (13) d'un clip de connexion électrique respectif (10), et dans lequel l'étape de clipage pour chaque clip de connexion électrique comprend l'engagement de l'ouverture (28) dans la plaque de mica (20) en utilisant les pattes (13).

17. Procédé selon l'une quelconque des revendications 11 à 16, comprenant en outre le montage du sous-ensemble de chauffage à résistance filaire et à plaque de mica (30) sur une armature (41).
